# EUROPEAN PATENT APPLICATION

(11) **EP 1 762 641 A2**
(43) Date of publication of application: **14.03.2007**
(21) Application number: 06254661.9
(22) Date of filing: 07.09.2006
(51) Int. Cl.: C25D 5/14, C25D 5/50, H05K 3/24

(54) **Metal duplex and method**

(30) Priority: 07.09.2005 US 714575 P
(71) Applicant: Rohm and Haas Electronic Materials LLC, Marlborough, MA 01752 (US)
(72) Inventor: Lau, Danny, On Lok Tsuen Fanling Hong Kong (CN); Kwok, Raymund W. M., Cho Kwo Ling Kowloon Hong Kong (CN)
(74) Representative: Kent, Venetia Katherine

(57) **Abstract**

Methods and articles are disclosed. The methods are directed to depositing nickel duplex layers on substrates to inhibit corrosion and improve solderability of the substrates. The substrates have a gold or gold alloy finish.

## Description

The present invention is directed to a low phosphorous containing metal duplex with a gold or gold alloy layer and method of making the low phosphorous metal duplex with the gold or gold alloy layer. More specifically, the present invention is directed to a low phosphorous containing metal duplex with a gold or gold alloy layer and method of making the low phosphorous metal duplex with the gold or gold alloy layer for inhibiting corrosion and improving solderability.

Prevention of corrosion of gold and gold alloys is a challenging problem in numerous industries. The corrosion of gold and gold alloys has been especially problematic in the electronic materials industry where corrosion may lead to faulty electrical contact between components in electronic devices. For example, gold and gold alloy coatings have been used in electronics and other applications for many years. In electronics they have been used as a solderable and corrosion resistive surface for contacts and connectors. They are also used in lead finishes for integrated circuit (IC) fabrication. However, gold finishes may not always prevent corrosion.

IC devices, having IC units, lead frames and passive components, such as capacitors and transistors, find wide use in products including consumer electronics, household appliances, computers, automobiles, telecommunications, robotics and military equipment. The IC unit encompasses IC chips and hybrid circuit nodules which include one or more of the IC chips and other electronic components on a plastic or ceramic support base.

Lead frames or connectors are a means to electrically interconnect an IC unit to external circuitry. The lead frame is formed from electrically conductive material such as copper or copper alloys, or by stamping or etching a metal blank into a plurality of leads defining a central area in which the IC unit is mounted. There are several attachment techniques by which the lead frames connect the IC units in an assembly. These include wirebonding, soldering, die-attach and encapsulation. Typically soldering is the means of joining the IC to the assembly. In all instances attachment requires a particular quality of the lead frame surface. Typically this means that the surface is corrosion free and ready for interaction with other components such as gold or aluminum wire, silver filled epoxy or solder.

One problem is long term solderability, defined as the ability of the surface finish to melt and make a good solder joint to other components without defects that impair the electrical or mechanical connection. Generally, soldering is an attachment procedure that usually involves three materials: (1) the substrate, (2) the component or other device which is desired to be attached to the substrate, and (3) the soldering material itself.

There are many factors that determine good solderability, the three most important of which are extent of corrosion, amount of co-deposited carbon, and extent of intermetallic compound formation. Corrosion is a natural occurring process because it is thermodynamically favorable. The rate of corrosion depends on temperature and time. The higher the temperature and the longer the exposure time, the thicker the corrosion.

Co-deposited carbon is determined by the plating chemistry one chooses to use. Bright finishes contain higher carbon contents than matte finishes. Matte finishes are normally rougher than bright finishes, and provide an increased surface area which results in the formation of more corrosion than typically are formed with bright finishes.

Intermetallic compound formation is a chemical reaction between metal coating and the underlying metal substrate. The rate of formation depends on temperature and time as well. Higher temperatures and longer times result in a thicker layer of intermetallic compounds.

Certain physical properties of gold, such as its relative porosity, translate into problems when gold is deposited onto a substrate. For instance, gold's porosity can create interstices on the plated surface. These small spaces can contribute to corrosion or actually accelerate corrosion through the galvanic coupling of the gold layer with the underlying base metal layer. This is believed to be due to the base metal substrate and any accompanying underlying metal layers which may be exposed to corrosive elements via the pores in the gold outer surface.

In addition, many applications include thermal exposure of coated lead frames. Diffusion of metal between layers under thermal aging conditions may cause a loss of surface quality if an underlying metal diffuses into a noble metal surface layer such as nickel into gold.

At least three different approaches to overcoming the corrosion problems have been attempted: 1) reducing the porosity of the coating, 2) inhibiting the galvanic effects caused by the electropotential differences of different metals, and 3) sealing the pores in the electroplated layer. Reducing the porosity has been studied extensively. Pulse plating of the gold and utilization of various wetting/grain refining agents in the gold plating bath affect the gold structure and are two factors contributing to a reduction in gold porosity. Often regular carbon bath treatments and good filtration practices in the series of electroplating baths or tanks combined with a preventive maintenance program help to maintain gold metal deposition levels and correspondingly low levels of surface porosity. A certain degree of porosity, however, continues to remain.

Pore closure, sealing and other corrosion inhibition methods have been tried but with limited success. Potential mechanisms using organic precipitates having corrosion inhibitive effects are known in the art. Many of these compounds were typically soluble in organic solvents and were deemed not to provide long term corrosion protection. Other methods of pore sealing or pore blocking are based on the formation of insoluble compounds inside pores. Such insoluble complexes and precipitates as are apparent to those of skill in the field also are potential candidates for pore blocking.

In addition to the problem of pore formation, exposing gold to elevated temperatures, such as in thermal aging, undesirably increases the gold's contact resistance. This increase in contact resistance compromises the performance of the gold as a conductor of current. In theory, workers believe that this problem arises from the diffusion of organic materials co-deposited with the gold to the contact surfaces. Various techniques for obviating this problem have been attempted heretofore, typically involving electrolytic polishing. However, none have proven completely satisfactory for this purpose and investigative efforts continue.

U.S. 6,287,896 to Yeh et al. discloses a thick nickel-cobalt alloy coating a copper or copper alloy base plate. The patent states that the thick nickel-cobalt layer is essential for reducing the effects of porosity and prevents the diffusion of copper from the base plate to the surface which is used for soldering. A nickel or nickel alloy coats the thick nickel-cobalt layer to prevent it from cracking, an inherent problem of the nickel-cobalt layer. A gold or gold alloy layer coats the nickel or nickel alloy layer. The gold or gold alloy layer allegedly improves solderability.

Although there are methods which attempt to address the corrosion and solderability problems on metal deposits, there is still a need for improved methods for inhibiting corrosion and improving solderability.

Methods include depositing a nickel layer on a substrate, depositing a layer of nickel phosphorous on the nickel layer and depositing a layer of gold or gold alloy on the nickel phosphorous layer, the nickel phosphorous layer includes 0.1wt% to 10wt% phosphorous. The combination of the nickel and nickel phosphorous layers inhibits or prevents the effects of thermal ageing, thus decreasing pore formation in the gold or gold alloy layer. The reduction of pores in the gold or gold alloy layer reduces or prevents corrosion of the underlying substrate. Solderability of the gold or gold alloy finish is thus improved.

In another aspect, methods include depositing 1 micron to 10 microns of a nickel layer on a substrate, depositing 0.1 micron to 5 microns of nickel phosphorous layer on the nickel layer, and depositing a gold or gold alloy layer on the nickel phosphorous layer, the nickel phosphorous layer includes 0.1 wt% to 10wt% phosphorous.

In a further aspect, articles include a nickel layer on a substrate, a nickel phosphorous layer on the nickel layer and a gold or gold alloy layer on the nickel phosphorous layer, the nickel phosphorous layer includes 0.1wt% to 10wt% phosphorous.
Figure 1 is a photograph 50X of a gold layer with pores on a nickel underlayer; and
Figure 2 is a photograph 50X of a gold layer with pores on a nickel phosphorous underlayer.

As used throughout this embodiment, the following abbreviations have the following meanings, unless the context clearly indicates otherwise: °C = degrees Centigrade; g = gram; mg = milligram; L = liter; ml = milliliter; Å = angstroms = 1x10⁻⁴ microns; ASD = amperes/dm²; and wt% = weight percent. The terms "depositing" and "plating" are used interchangeably throughout this specification. All numerical ranges are inclusive and combinable in any order, except where it is logical that such numerical ranges are constrained to add up to 100%.

Methods include depositing a nickel layer on a substrate, depositing a layer of nickel phosphorous on the nickel layer and depositing a gold or gold alloy layer on the nickel phosphorous layer, the nickel phosphorous layer includes 0.1wt% to 10wt% of phosphorous. The combination of the nickel and nickel phosphorous layers reduces the effects of thermal aging, thus decreasing pore formation in gold and gold alloy layers. The reduction of pore formation in turn reduces or eliminates corrosion of the underlying metal substrate and also improves solderability of the gold or gold alloy layer. The nickel and nickel phosphorous layers also reduce or inhibit the migration of nickel into the gold or gold alloy layer.

Optionally, prior to metallization the substrate may be cleaned. Any suitable cleaning process may be used which is acceptable in the metallization arts. Typically, the substrate is ultrasonically cleaned in a cleaning solution. Such cleaning solutions may include silicate compounds, alkali metal carbonates and other compounds such as alkali metal hydroxides, glycol ethers and one or more chelating agents. Cleaning may be done at temperatures of from 30° C to 80° C.

Optionally, following the cleaning step, the substrate may be activated with a suitable acid such as a mineral acid. Dilute concentrations of mineral acids are used. An example of such an acid is sulfuric acid. However, other mineral acids may be used such a hydrochloric acid and nitric acid. The acids are used at conventional concentrations well known in the art. Activation typically is done at temperatures from room temperature to 30° C.

The substrate is then plated with a deposit of nickel metal. Bath temperatures range from 30° C to 70° C or such as from 40° C to 60° C.

Any suitable nickel plating bath may be used to deposit the nickel layer on the substrate. Such nickel plating baths include one or more sources of nickel ions. Sources of nickel ions include, but are not limited to, nickel halides such as nickel chloride, nickel sulfate and nickel sulfamate. Such sources of nickel ions are included in the nickel baths in amounts of 50 gm/L to 500 gm/L, or such as from 100 gm/L to 250 gm/L.

In addition to the one or more sources of nickel ions, the nickel plating baths may include one or more additives. Such additives include, but are not limited to, brighteners, grain refiners, levelers, surface active agents, antipitting agents, chelating agents, buffers, biocides and other additives known to those of skill in the art to tailor the bath to a desired bright or matt finish and throwing power.

Brighteners include, but are not limited to, aromatic sulfonates, sulfonamides, sulfonimides, aliphatic and aromatic-aliphatic olefinically or acetylenically unsaturated sulfonates, sulfonamides and sulfonimides. Examples of such brighteners are sodium o-sulfobenzimide, disodium 1,5-naphthalene disulfonate, trisodium 1,3,6-naphthalene trisulfonate, sodium benzene monosulfonate, dibenzene sulfonamide, sodium allyl sulfonate, sodium 3-chloro-2-butene-1-sulfonate, sodium β-styrene sulfonate, sodium propargyl sulfonate, monoallyl sulfamide, diallyl sulfamide and allyl sulfonamide. Such brighteners may be used in conventional amounts such as 0.5 g/L to 10 g/L, or such as 2 g/L to 6 g/L.

Other brighteners include, but are not limited to, reaction products of epoxides with alphahydroxy acetylenic alcohols such as diethoxylated 2-butyne-1,4-diol or dipropoxylated 2-butyne-1,4-diol, N-heterocyclics, other acetylenic compounds, active sulfur compounds and dyestuffs. Examples of such brighteners are 1,4-di-(β-hydroxyethoxy)-2-butyne, 1,4-di-(β-hydroxy-γ-chloropropoxy)-2-butyne, 1,4-di-(β-,γ-epoxypropoxy)-2-butyne, 1,4-di-(β-hydroxy-γ-butenoxy)-2-butyne, 1,4-di-(2'-hydroxy-4'-oxa-6'-heptenoxy)-2-butyne, N-(2,3-dichloro-2-propenyl)-pyridinium chloride, 2,4,6-trimethyl N-propargyl pyridinium bromide, N-allylquinaldinium bromide, 2-butyne-1,4-diol, propargyl alcohol, 2-methyl-3-butyn-2-ol, quinaldyl-N-propanesulfonic acid betaine, quinaldine dimethyl sulfate, N-allylpyridinium bromide, isoquinaldyl-N-propanesulfonic acid betaine, isoquinaldine dimethyl sulfate, N-allylisoquinaldine bromide, disulfonated 1,4-di-(β-hydroxyethoxy)-2-butyne, 1-(β-hydroxyethoxy)-2-propyne, 1-(β-hydroxypropoxy)-2-propyne, sulfonated 1-(β-hydroxyethoxy)-2-propyne, phenosafranin and fuchsin. Such brighteners are included in conventional amounts such as, for example, 5 mg/L to 1000 mg/L, or such as from 20 mg/L to 500 mg/L.

Any suitable surface active agent may be used. Such surface active agents include, but are not limited to, ionic surfactants such as cationic and anionic surfactants, non-ionic surfactants and amphoteric surfactants. Surfactants may be used in conventional amounts such as, for example, 0.05 gm/L to 30 gm/L, or such as from 1 gm/L to 20 gm/L or such as from 5 gm/L to 10 gm/L.

An example of a suitable surfactant is naphthalene sulfonated with 1 to 8 sulfonic acid groups (-SO₃H). Examples of such surfactants are naphthalene-1,3,6-trissulfonic acid and naphthalene-1,3,7-trissulfonic acid. The alkali metal salts such as the sodium and potassium salts also may be used.

Examples of other suitable surfactants are salts of alkyl hydrogen sulfates such as sodium lauryl sulfate, sodium lauryl ether-sulfate and sodium di-alkylsulfosuccinates. Examples of other surfactants which may be used are quaternary ammonium salts including perfluorinated quaternary amines such as perfluoro dodecyl trimethyl ammonium fluoride.

Suitable chelating agents include, but are not limited to, amino carboxylic acids, polycarboxylic acids and polyphosphonic acids. Such chelating agents may be used in conventional amounts such as 0.01 moles/L to 3 moles/L or such as from 0.1 moles/L to 0.5 moles/L.

The pH of the nickel baths may range from 1 to 10, or such as from 3 to 8. The pH of the nickel baths may be maintained by a variety of means. Any desired acid or base may be used, and any inorganic acid, organic acid, inorganic base, or organic base may be used. Besides acids such as sulfuric acid, hydrochloric acid, or sulfamic acid, acids used as chelating agents such as acetic acid, amino acetic acid or ascorbic acid also may be used. Besides inorganic bases such as sodium hydroxide or potassium hydroxide and organic bases such as various types of amines, bases such as nickel carbonate also may be used. In addition, a pH buffering ingredient such as boric acid may be used if the pH tends to fluctuate due to operating conditions. The buffers may be added in amounts as needed to maintain a desired pH.

Other additives may be added to the nickel metal plating baths which are conventional and well known those of skill in the art. They are used in conventional amounts to tailor the nickel layer to a desired matt, semi-bright or bright finish.

Nickel is deposited on the substrate until a nickel layer of from 1 micron to 10 microns, or such as from 2 microns to 5 microns is formed on the substrate. The nickel layer is then plated with a layer of nickel phosphorous using a nickel phosphorous bath.

The nickel phosphorous bath includes one or more sources of nickel ions as described above, and may include one or more of the additives as described above. In addition, the nickel phosphorous bath includes one or more sources of phosphorous. Any suitable phosphorous acid or phosphoric acid or salt thereof and mixtures may be used. Phosphorous acids and phosphoric acids and their salts are included in the baths in amounts of 5 gm/L to 100 gm/L, or such as from 10 gm/L to 80 gm/L, or such as from 20 gm/L to 50 gm/L. Phosphorous acid has the general formula: H₃PO₃ and also is known as orthophosphorous acid. Phosphoric acids include, but are not limited to, inorganic phosphoric acids such as phosphoric acid (H₃PO₄), also known as orthophosphoric acid. Polyphosphoric acids also may be used. Inorganic phosphoric acids may be represented by the formula: Hₙ₊₂PₙO₃ₙ₊₁, where n is an integer of 1 or greater. When n is an integer of 2 or greater, the formula represents a polyphosphoric acid. When the inorganic phosphoric acid is a polyphosphoric acid, typically, n is an integer such that the polyphosphoric acid has an average molecular weight of 110 to 1,500 atomic weight units. Typically, phosphorous acid is used.

Salts of phosphoric acids such as alkali metal phosphates and ammonium phosphate may be used. Alkali metal phosphates include dibasic sodium phosphate, tribasic sodium phosphate, dibasic potassium phosphate and tribasic potassium phosphate. Salts of the polyphosphoric acids also may be used. Mixtures of the inorganic phosphoric acids and their salts also may be used. Such acids are commercially available or may be made according to methods described in the literature.

The nickel phosphorous layer is deposited on the nickel layer at the same bath temperatures as the nickel layer is deposited on the substrate. Deposition continues until a nickel phosphorous layer of 0.1 microns to 5 microns or such as from 0.2 microns to 1 micron is deposited on the nickel layer to form a duplex.

Typically, the weight ratio of nickel to nickel phosphorous in the duplex is from 2:1 to 8:1. The nickel and nickel phosphorous layers may be deposited by any suitable electrolytic deposition method known in the art. Conventional plating apparatus may be used to deposit the nickel and nickel phosphorous layers. Current densities may range from 1 ASD to 20 ASD, or such as from 5 ASD to 15 ASD.

Typically, the nickel and nickel phosphorous duplex layer is 2 microns to 3 microns thick. After the nickel and nickel phosphorous layers are deposited on the substrate, a surface finish of gold or gold alloy is deposited on the nickel phosphorous layer.

The article formed by the methods described above includes a substrate plated with a nickel layer and a nickel phosphorous layer over the nickel layer to form the duplex. Phosphorous content of the nickel phosphorous layer may range from 0.1wt% to 10wt%, or such as from 0.5wt% to less than 10wt%, or such as from 1wt% to 9wt%, or such as from 2wt% to 8wt%, or such as from 3wt% to 7wt%. A gold or gold alloy layer is deposited over the nickel phosphorous layer to form an article. The duplex layers composed of the nickel and nickel phosphorous layers inhibit pore formation in the gold or gold alloy layer and inhibit nickel migration into the gold or gold alloy layer. Connectors soldered to the gold or gold alloy coated articles are more secure and less likely to separate than gold or gold alloy coated articles without the duplex layer.

Gold or gold alloy may be deposited on the nickel phosphorous layer using any suitable source of gold ions as well as alloying metal ions. Sources of gold ions include, but are not limited to, sodium dicyanoaurate (I), ammonium dicyanoaurate (I) and other dicyanoauric acid (I) salts; potassium tetracyanoaurate (III), sodium tetracyanoaurate (III), ammonium tetracyanoaurate (III) and other tetracyanoauric acid (III) salts; gold (I) cyanide, gold (III) cyanide; dichloroauric acid (I) salts; tetrachloroauric acid (III), sodium tetrachloroaurate (III) and other tetrachloroauric acid (III) compounds; ammonium gold sulfite, potassium gold sulfite, sodium gold sulfite and other sulfurous acid gold salts; gold oxide, gold hydroxide and other alkali metal salts thereof; and nitrosulphito gold complexes. The sources of gold typically are included in conventional amounts such as 0.1 gm/L to 10 g/L or such as from 1 gm/L to 5 gm/L.

Alloying metals include, but are not limited to, copper, nickel, zinc, cobalt, silver, the platinum group metals, cadmium, lead, mercury, arsenic, tin, selenium, tellurium, manganese, magnesium, indium, antimony, iron, bismuth and thallium. Typically the alloying metal is cobalt. Sources of such alloying metals are well known in the art. The sources of alloying metals are included in the bath in conventional amounts and vary widely depending on the type of alloying metal used.

In addition to the sources of gold and alloying metals the gold and gold alloy baths may include one or more additives. Such additives include, but are not limited to, surfactants, brighteners, levelers, complexing agents, chelating agents, buffers and biocides. Such additives are included in conventional amounts and are well known to those of skill in the art.

The gold or gold alloy may be deposited on the nickel phosphorous layer by any suitable method known in the art. Such methods include, but are not limited to, electrolytic deposition and immersion deposition. Typically, the gold or gold alloy is deposited electrolytically. Current densities for depositing gold and gold alloys electrolytically range from 1 ASD to 30 ASD, or such as form 5 ASD to 20 ASD.

After the gold or gold alloy is deposited on the nickel phosphorous layer, typically it undergoes thermal aging. Thermal aging may be done by any suitable method known in the art. Presently, there are no standard thermal aging requirements and various methods are used. Such methods include, but are not limited to, steam aging and dry baking. The nickel and nickel phosphorous duplex inhibits surface diffusion of nickel into the gold surface finish, thus solderability is improved.

In addition to preventing the diffusion of less noble metals into gold and gold alloys, the duplex also reduces or inhibits the porosity of the gold and gold alloy layers, and reduces oxygen penetration of the metal layers. The reduction of the porosity of the gold and gold alloys reduces or prevents undesired oxidation of underlying metals. This in turn improves the solderability of the gold and gold alloy surface finish and decreases contact resistance.

The methods may be used to deposit the duplex of nickel and nickel phosphorous on any suitable substrate. Typically such substrates are metals or metal alloys. Suitable metals include, but are not limited to, copper, iron, and their alloys, stainless steel, and precious metals such as gold, platinum, palladium, silver and their alloys. Typically, the substrates are copper, copper alloys, iron and iron alloys. Suitable copper alloys include, but are not limited to, copper-tin, copper-silver, copper-gold, copper-silver-tin, copper-phosphorous-gold, copper-zinc, copper-silver-magnesium, copper-iron-zinc, copper-tin-nickel-silicon, copper-zirconium, copper-iron-phosphorous-zinc and copper-nickel-silicon-magnesium. Suitable iron alloys include, but are not limited to, iron-copper and iron nickel. Such substrates include, but are not limited to components of electrical devices such as printed wiring boards, connectors, bumps on wafers, lead frames as well as passive components such as resistors and capacitors for IC units.

The following embodiments of the invention are included to further illustrate the invention and are not intended to limit its scope.

### Example 1 (Comparative)

Three (3) copper-tin alloy lead frames were ultrasonically cleaned at 65° C for 30 seconds in a cleaning solution containing 100 g/L of RONACLEAN^{™} CP-100, which is a silicate containing cleaning composition obtainable from Rohm and Haas Company, Philadelphia, PA, U.S.A.

After cleaning, each lead frame was then immersed into a solution of 100 ml/L of technical grade sulfuric acid at room temperature for 10 seconds. Each lead frame was then electroplated with a nickel layer of 2 microns. The nickel bath used to plate each lead frame had the formula disclosed in Table 1 below.

**TABLE 1**

| **COMPONENT** | **CONCENTRATION** |
|---|---|
| Nickel Sulfamate | 125 g/L |
| Nickel Chloride | 8 g/L |
| Boric Acid | 35 g/L |
| Sulfonated Naphthalene Compound | 0.5 g/L |
| Benzosulfimide Compound | 5 g/L |
| Aldehyde | 0.5 g/L |
| Water | Balance |

The pH of the nickel bath was 4 and the temperature of the bath was 50° C. Each lead frame was then placed in a Hull cell containing the electrolytic nickel bath. The lead frame functioned as the cathode and the anode was a sulfur/nickel electrode. The nickel bath was paddle agitated during deposition. The apparatus was connected to a conventional rectifier. Current density was at 10 ASD. Nickel deposition was done over a period of 90 seconds.

Two (2) of the nickel plated lead frames were then plated with a nickel phosphorous layer 1 micron thick. The nickel phosphorous bath used to plate the two lead frames had the formulation as shown in Table 2 below.

**TABLE 2**

| **COMPONENT** | **CONCENTRATION** |
|---|---|
| Nickel Sulfamate | 125 g/L |
| Phosphorous Acid | 50 g/L |
| Boric Acid | 35 g/L |
| Digylceryl Ether | 30 mg/L |
| Salt of an Alkyl Hydrogen Sulfate | 1 g/L |
| Water | Balance |

The nickel phosphorous bath had a pH of 1 and was at a temperature of 60° C during nickel phosphorous deposition. Nickel phosphorous was done in Hull cells with paddle agitation at a current density of 10 ASD for one lead frame and 5 ASD for the second lead frame. Electroplating was done on one lead frame for 60 seconds (10 ASD) and on the second lead frame for 30 seconds (5 ASD). The nickel phosphorous layer plated at 10 ASD had a phosphorous content of 6wt%, and the nickel phosphorous layer plated at 5 ASD had a phosphorous content of 9wt%. The phosphorous content was measured by conventional energy dispersive X-ray spectroscopy. A 1x1 mm area was measured.

Each of the three lead frames was then plated with a gold layer 0.2 to 0.5 microns thick. The gold electrolyte included 12 g/L of gold ions from sodium gold sulfite and conventional gold electrolyte additives. Gold plating was done at a current density of 3 ASD for 4 seconds at 35° C.

Each lead frame was then soldered with eutectic tin/lead solder at 235°C. The soldered lead frames were then steam aged according to Military Specification 883C, Method 2003 which involves steam aging at 95° C and 95% relative humidity for 8 hours. This simulated a shelf life of at least 6 months.

The zero crossing time was then determined for each lead frame for solderability performance after steam aging. The zero crossing time was determined with Menisco ST-50 solderability tester. The zero crossing time for the lead frame without the nickel phosphorous layer was 3.2 seconds, the zero crossing time for the lead frame with the 6wt% phosphorous content was 1.8 seconds, and the zero crossing time for the lead frame with the phosphorous content of 9wt% was 0.9 seconds. Accordingly, the nickel and nickel phosphorous layers showed better solderability performance than the lead frame without the nickel and nickel phosphorous layers.

### Example 2 (Comparative)

Two (2) brass lead frames were ultrasonically cleaned at 60° C for 30 seconds in RONACLEAN^{™} CP-100 cleaning solution. The lead frames were then immersed into a solution of 100 ml/L of technical grade sulfuric acid at room temperature for 10 seconds. Each lead frame was then electroplated with a 2 microns layer of nickel from a nickel bath having the formula in Table 3 below.

**TABLE 3**

| **COMPONENT** | **CONCENTRATION** |
|---|---|
| Nickel Sulfamate | 125 g/L |
| Nickel Chloride | 8 g/L |
| Aminoacetic Acid | 30 g/L |
| Sulfonated Naphthalene Compound | 1 g/L |
| Benzosulfimide | 5 g/L |
| Aldehyde | 0.5 g/L |
| Water | Balance |

The pH of the nickel bath was 3 and the temperature of the bath was 50° C. Each lead frame was placed in a Hull cell containing the electrolytic nickel bath. Nickel was deposited on the lead frames at a current density of 10 ASD. Nickel deposition was done over 80 seconds. The bath was paddle agitated during electroplating.

One of the lead frames was then plated with a 1 micron layer of nickel phosphorous using the bath disclosed in Table 4 below.

**TABLE 4**

| **COMPONENT** | **CONCENTRATION** |
|---|---|
| Nickel Sulfamate | 125 g/L |
| Phosphorous Acid | 50 g/L |
| Boric Acid | 30 g/L |
| Aminoacetic Acid | 25 g/L |
| Sulfonated Naphthalene Compound | 0.5 g/L |
| Diglyceral Ether | 35 mg/L |
| Water | Balance |

The phosphorous content of the nickel phosphorous layer was 9wt%. The pH of the bath was 1 and electroplating was done at 60° C. The electroplating was done in a Hull cell with paddle agitation. The current density was maintained at 5 ASD and done for 20 seconds.

Each lead frame was then plated with a gold layer of 0.2 to 0.5 microns. The gold bath included 12 g/L of gold ions from sodium gold sulfite, and conventional gold electrolyte additives. Gold plating was done at a current density of 3 ASD for 4 seconds at 30° C.

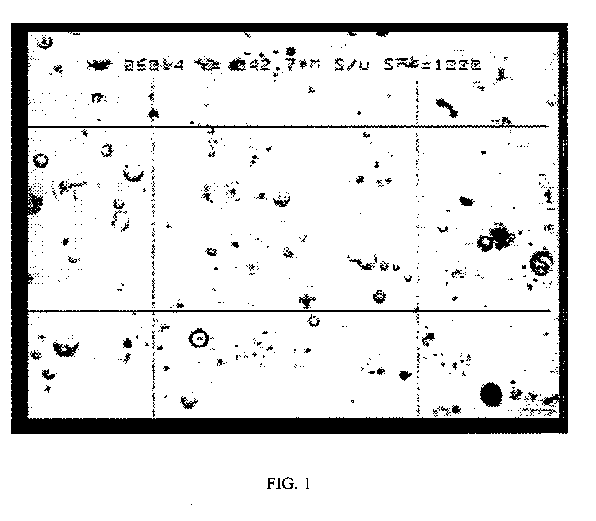

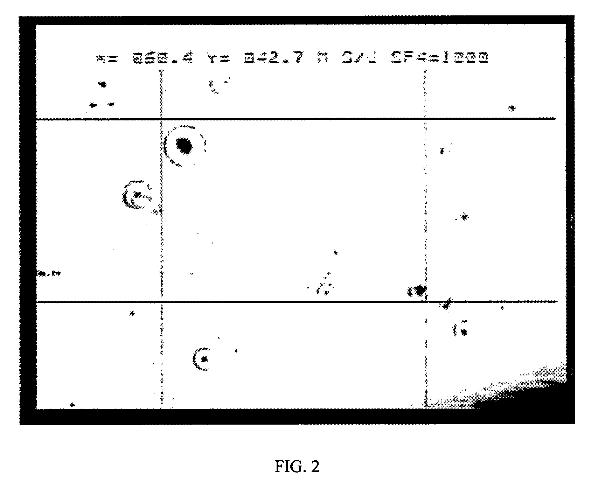

Each lead frame was then placed on a plastic holder in a dessicator. Fuming nitric acid vapor with a concentration greater than 65% was added to the dessicator for 1 hour at room temperature. The nitric acid was then rinsed off using deionized water. The gold surface of each lead frame was then placed under a Nomarski microscope at 50X to examine the gold layers for any pore formation. Figure 1 shows the gold surface of the lead frame which was not plated with the nickel phosphorous layer. Numerous pores formed in the gold layer. In contrast, Figure 2 shows the gold layer on the lead frame which contained the nickel phosphorous layer. Pore formation was sparse. Accordingly, the nickel and nickel phosphorous layers under the gold layer was able to reduce the formation of pores in gold.

### Example 3 (Comparative)

Three (3) brass lead frames were ultrasonically cleaned using 100 g/L of ROANACLEAN^{™} CP-100 at 65° C for 30 seconds. After cleaning, each connector was then immersed into a solution of 100 ml/L of technical grade sulfuric acid at room temperature for 10 seconds. Each lead frame was then plated with a nickel layer of 2 microns using the nickel electrolyte in Table 1 above. Nickel deposition was done in a Hull cell at a pH of 4 and at a temperature of 50° C. The current density was 10 ASD and was done over 80 seconds.

Two (2) of the lead frames were then plated with a 1 micron layer of nickel phosphorous. The nickel phosphorous electrolyte used was the same as that disclosed in Table 2 above. The pH of the electrolyte was 2 and nickel phosphorous deposition was done at a temperature of 50° C. The current density for one of the plating baths was 10 ASD and the other was 5 ASD. Nickel phosphorous deposition was done over 20 seconds for each bath.

All three of the lead frames were then electroplated with gold in a Hull cell at a current density of 3 ASD for 4 seconds. The gold electrolyte included 12 g/L of gold ions from gold sulfite and conventional gold electrolyte additives. The temperature of the bath was 30° C.

Each of the gold plated lead frames was then steam aged according to Military Specification 883C, Method 2003 which involves steam ageing at 95° C and 95% relative humidity for 8 hours. The lead frames were then tested for oxygen penetration into the nickel layers, and nickel migration into the gold layers.

Table 4 below discloses the results of the tests. The atomic% of each element at different sputter depths was measured using a conventional X-ray photoelectron spectrometer inside a ultrahigh vacuum chamber.

**TABLE 4**

| | **Ni/Au** | | | **Ni/Ni-P/Au (7wt% P)** | | | | **Ni/Ni-P/Au (10wt% P)** | | | |
|---|---|---|---|---|---|---|---|---|---|---|---|
| **Depth (Å)** | **Au** | **Ni** | **O** | **Au** | **Ni** | **O** | **P** | **Au** | **Ni** | **O** | **P** |
| 0 | 8.9 | 32.3 | 58.8 | 23.2 | 19.9 | 56.9 | - | 8.1 | 36.3 | 55.6 | - |
| 100 | 15.1 | 50.6 | 34.3 | 97.8 | 5.4 | 0.4 | - | 77.1 | 17.7 | 5.2 | - |
| 200 | 14.1 | 44.4 | 41.5 | 89.6 | 2.2 | - | - | 88.7 | 7.3 | 2.7 | 1.3 |
| 300 | 6.2 | 54.1 | 39.7 | 89.6 | 9.3 | - | 1.1 | 91.9 | 7.1 | 1.0 | - |
| 330 | 5.4 | 54.4 | 40.42 | 58.1 | 37.5 | - | 4.4 | 85.0 | 13.1 | - | 1.9 |
| 360 | 4.9 | 55.4 | 39.7 | 27.6 | 66.0 | - | 6.4 | 63.4 | 29.4 | 2.1 | 5.1 |
| 390 | 4.5 | 56.1 | 39.4 | 13.2 | 82.2 | - | 4.6 | 42.6 | 48.0 | 1.0 | 8.4 |
| 420 | 4.5 | 56.2 | 39.3 | 7.4 | 88.1 | - | 4.5 | 26.5 | 63.4 | 1.9 | 8.2 |
| 450 | 4.2 | 56.7 | 39.1 | 5.2 | 91.1 | - | 3.7 | 16.5 | 75.6 | 2.4 | 5.5 |
| 480 | 4.3 | 56.3 | 39.4 | 4.3 | 91.7 | - | 4.0 | 11.0 | 82.4 | 1.9 | 4.7 |
| 510 | 4.2 | 56.9 | 38.9 | 3.7 | 92.8 | - | 3.5 | 7.5 | 88.5 | 1.8 | 2.2 |
| 540 | 4.0 | 56.7 | 39.3 | 3.5 | 92.5 | 0.7 | 3.3 | 5.6 | 91.6 | 1.8 | 1.0 |
| 570 | 4.0 | 56.9 | 39.1 | 3.3 | 92.0 | 0.6 | 4.1 | 4.3 | 93.6 | 1.8 | 0.3 |
| 600 | 3.9 | 57.1 | 39.0 | 3.1 | 92.5 | 0.4 | 4.0 | 3.4 | 94.9 | 1.7 | - |
| 630 | 3.9 | 57.1 | 39.0 | 2.9 | 92.7 | 0.7 | 3.7 | 2.6 | 95.6 | 1.8 | - |
| 660 | 3.9 | 57.5 | 38.6 | 2.9 | 92.7 | 0.4 | 4.0 | 2.3 | 96.0 | 1.7 | - |
| 690 | 3.9 | 57.4 | 38.7 | 2.8 | 93.3 | 0.4 | 3.5 | 2.1 | 96.2 | 1.7 | - |
| 720 | 3.9 | 57.4 | 38.7 | 2.8 | 93.5 | 0.3 | 3.4 | 2.1 | 96.2 | 1.7 | - |
| 750 | 3.8 | 57.8 | 38.4 | 2.7 | 93.0 | 0.7 | 3.6 | 1.6 | 96.8 | 1.6 | - |
| 780 | 3.9 | 57.4 | 38.7 | 2.6 | 93.1 | 0.4 | 3.9 | 1.5 | 96.7 | 1.8 | - |
| 810 | 3.8 | 58.0 | 38.2 | 2.5 | 93.5 | 0.4 | 3.6 | 1.4 | 96.7 | 1.9 | - |
| 840 | 3.7 | 58.0 | 38.3 | 2.6 | 93.3 | 0.4 | 3.7 | 1.3 | 97.0 | 1.7 | - |
| 870 | 3.8 | 58.7 | 37.5 | 2.4 | 93.5 | 0.5 | 3.6 | 1.2 | 97.2 | 1.6 | - |
| 900 | 3.6 | 58.1 | 38.3 | 2.5 | 93.0 | 0.3 | 4.2 | 1.2 | 96.9 | 1.9 | - |

The results in the table above show that the oxygen content of the metal layers of the lead frames which were plated with a nickel phosphorous layer were far below that of the lead frame with just the nickel layer. The atomic% of oxygen in the metal layers of the lead frame with the nickel phosphorous layer containing 10wt% of phosphorous had a high oxygen content of 5.2 atomic% at a depth of 100 Å and a low oxygen content of 0 atomic% at 330 Å. The average atomic% oxygen for all depths was 4.1. The lead frame with the phosphorous content of 7wt% had a high oxygen content of 0.7 atomic% at 540 Å and a low oxygen content of 0 atomic% at 200-510 Å. The average oxygen content for all depths was 2.6 atomic%. In contrast, the lead frame without the nickel phosphorous layer had a high oxygen content of 41.5 atomic% at 200 Å and a low oxygen content of 34.3 atomic% at 100 Å. The average oxygen content for all depths was 36 atomic%. Thus, the nickel phosphorous layers reduced oxygen penetration.

### Example 4

Example 2 is repeated except that an aqueous gold cobalt alloy electroplating bath is used to plate a gold-cobalt layer on the nickel or nickel phosphorous layer. The gold-cobalt alloy bath includes 4 g/L of potassium gold cyanide, 1 g/L of cobalt sulfate (0.25 g/L of cobalt ions) and 150 g/L of methylene phosphonic acid. The pH of the aqueous gold-cobalt bath is 4. The pH of the bath is maintained with potassium hydroxide. The bath is maintained at 40° C and the current density is 1 ASD. Electroplating is done until a 0.2 to 0.5 microns layer of gold-cobalt is formed on the nickel phosphorous layer of each lead frame.

Each lead frame is then placed on a plastic holder in a dessicator and exposed to fuming nitric acid as in Example 2. The gold-cobalt layer on the lead frame with the duplex is expected to have fewer pores than the gold-cobalt layer on the lead frame with just the nickel layer.

### Example 5

Example 4 is repeated except that the aqueous gold-cobalt alloy electroplating bath includes 4 g/L of potassium gold cyanide, 1 g/L of cobalt as tetrapotassium salt of cobalt methylene phosphonic acid, 124 g/L of tripotassium citrate, 29 g/L of citric acid and 45 g/L of monopotassium phosphate. The pH of the bath is maintained at 5, and the bath temperature is maintained to 35° C. The current density is at 1 ASD and plating is done to form a 0.2 to 0.5 microns layer of gold-cobalt on each lead frame.

After treating each lead frame with fuming nitric acid, the lead frame with the duplex layer is expected to have a gold-cobalt layer with fewer pores than the gold-cobalt layer on the lead frame without the duplex layer.

## Claims

1. A method comprising depositing a nickel layer on a substrate, depositing a nickel phosphorous layer on the nickel layer and depositing a gold or gold alloy layer on the nickel phosphorous, the nickel phosphorous layer comprises 0.1wt% to 10wt% of phosphorous.

2. The method of claim 1, wherein the nickel phosphorous layer comprises 1wt% to 9wt% of phosphorous.

3. A method comprising depositing 1 micron to 10 microns of a nickel layer on a substrate, depositing 0.1 microns to 5 microns of a nickel phosphorous layer on the nickel layer, and depositing a gold or gold alloy layer on the nickel phosphorous layer, the nickel phosphorous layer comprises 1wt% to 10wt% of phosphorous.

4. The method of claim 3, further comprising the step of thermal aging the gold or gold alloy layer.

5. An article comprising a nickel layer on a substrate and a nickel phosphorous layer on the nickel layer a gold or gold alloy on the nickel phosphorous layer, the nickel phosphorous layer comprises 0.1wt% to 10wt% of phosphorous.

6. The article of claim 5, wherein the nickel phosphorous layer comprises 1wt% to 9wt% of phosphorous.

7. The article of claim 5, wherein the nickel layer is 1 micron to 10 microns thick and the nickel phosphorous layer is 0.1 microns to 5 microns thick.

8. The article of claim 5, wherein the article is a printed wiring board, a lead frame, a connector, wafer bump or passive component.
